# EUROPEAN PATENT SPECIFICATION

(11) **EP 3 115 744 B1**
(45) Date of publication and mention of the grant of the patent: **05.02.2020**
(21) Application number: 15176161.6
(22) Date of filing: 09.07.2015
(51) Int. Cl.: G01B 15/02, G01N 23/225, G01R 31/305, H01J 37/26

(54) **DEVICE FOR PRODUCING A PATCH OF A LAYER ON A SUBSTRATE AND MEASURING THE THICKNESS OF THE PATCH AND METHOD OF MEASURING A THICKNESS OF A PATCH OF A LAYER STRUCTURE ON A SUBSTRATE**
VORRICHTUNG ZUR HERSTELLUNG EINER SCHICHTSTRUKTUR AUF EINEM SUBSTRAT UND ZUR MESSUNG DER DICKE DER SCHICHTSTRUKTUR SOWIE VERFAHREN ZUR MESSUNG DER DICKE EINER SCHICHTSTRUKTUR AUF EINEM SUBSTRAT
DISPOSITIF DE PRODUCTION D'UNE PIÈCE D'UNE STRUCTURE EN COUCHES SUR UN SUBSTRAT ET DE MESURE DE L'ÉPAISSEUR D'UNE TELLE PIÈCE ET PROCÉDÉ DE MESURE DE L'ÉPAISSEUR D'UNE TELLE PIÈCE

(43) Date of publication of application: 11.01.2017
(73) Proprietor: TE Connectivity Germany GmbH, 64625 Bensheim (DE); TE Connectivity Corporation, Berwyn, PA 19312 (US)
(72) Inventor: Sachs, Sönke, 60385 Frankfurt am Main (DE); Schmidt, Helge, 67346 Speyer (DE); Reeder, Craig, Fremont, CA California 94536 (US); Sarraf, David, Elizabethtown, PA Pennsylvania 17022 (US); Panos, Konstantinos, 70771 Leinfelden-Echterdingen (DE); Myers, Marjorie, Mount Wolf, PA Pennsylvania 17347 (US); Freckmann, Dominique, San Francisco, CA California 94103 (US); Weier, Eva, 47058 Duisburg (DE)
(74) Representative: Grünecker Patent- und Rechtsanwälte PartG mbB

(56) References cited:
- EP-A1- 1 867 949
- JP-B2- 4 673 278
- US-A- 5 703 361
- US-B1- 6 787 773

## Description

The invention relates to a method of measuring a thickness of a patch of a layer structure on a substrate, in particular a functional area of an electric element, and a device for producing a patch of a layer structure on a substrate and measuring the thickness of the patch. An electric element can for example be a contact element for making contact to a counter contact element. In this case, a functional area can be an area that is optimized for a low resistance or a high hardness/durability.

Systems with a patch of a layer structure on a substrate can be produced at high speed, for example in strip-like form in an automated manner. This can be done by mechanically applying a material like a metal paste on a substrate, for example by printing the material on the substrate, and heating the material with an electron beam. However, current methods of measuring the thickness of the patch are relatively slow.

In JP4673278 B2, the thickness of a film in a thin-filmed test piece is measured by a scanning transmission electron microscope. US5703361 A1 shows a circuit scanning device for use in mapping the lateral dimensions and positions of a conductive layer of an integrated circuit. EP1867949 intends to provide a technique for promptly and accurately measuring the thickness of an oxide film that has a thickness in the range of 10 nm to 100 nm and is formed on a galvanized steel sheet with electrons. US6787773 B1 shows an X-ray microanalysis test system comprising a beam generator which induces X-rays to emanate from a semiconductor device containing film stacks, wherein the charged particle beam will penetrate at least two layers of a film stack on a semiconductor device so that these layers may be tested.

The object of the invention is to provide a solution that allows a fast measurement of the thickness.

This object is achieved by a device for producing a patch of a layer structure on a substrate by applying a material onto the substrate and melting the material by directing a high energetic electron beam onto the material, and for measuring a thickness of the patch, in particular a functional area of an electrical element, comprising an electron source for emitting an electron beam, an electron acceleration device for accelerating the electrons in the electron beam, a detector for detecting a signal coming from the patch that is subjected to the electron beam, the device being adapted to move the patch and the electron beam relative to each other, and wherein the device comprises an analyzing device for determining the thickness of the patch, wherein the device is adapted to melt the patch with the electron beam.

Further, the object is achieved by a method of measuring a thickness of a patch of a layer structure on a substrate, in particular a functional area of an electric element, wherein the electron beam is emitted, accelerated and directed to the patch, wherein the patch is moved relative to the electron beam, and wherein a signal coming from the patch is detected and the thickness of the patch is determined, wherein the electron beam is used for melting the patch.

The relative movement between the patch and the electron beam allows to measure the thickness in a production environment at high speeds.

The inventive solution can further be improved by the following further developments and improvements which are independent of each other and advantageous on their own.

The electrons can be accelerated to high speeds and high energy for example by a high voltage. The electron acceleration device can therefore be a high energy electron acceleration device. High energy electrons can go deeper into the patch and thus, for example, measure thicker patches. Furthermore, high energy electrons can trigger processes that are different from the ones that are triggered when low energy electrons are used. In particular, electron energy of several thousand volts or tens of thousands of volts can be used.

In order to allow a fast measurement, the electron beam can have a high density of electrons. Thus, the electron beam can have a high current.

In order to allow a defined forming of the electron beam, the thickness measurement device can comprise an electron beam forming device. Such an electron beam-forming device can comprise components that generate electric or magnetic fields that can alter the shape, diameter and/or size of the electron beam.

The thickness measurement device can comprise an electron beam focusing device. In this way, a small part of the patch can be measured. The electron beam can be focused on the surface of the patch or in the patch. A focus point can thus be set to be on the surface of the patch or in the patch. The spot size in the focus can be very small, in particular less than 100 µm in diameter. With such a small spot size, it is for example possible to check the homogeneity of the finish of the patch. It can be checked whether the thickness in the patch is uniform or whether thickness variations exist.

In another advantageous development that allows to average the measurement, the electron beam can be widened on the surface of the patch or in the patch. This also allows using a lower electron density in the electron beam, and thus avoiding possible damages due to high electron and energy densities.

The thickness measurement device can comprise an electron beam deflection device. An electron beam deflection device can serve to direct the beam to a desired position. It can allow a compact design of the thickness measurement device.

The electron beam deflection device can move the electron beam over the patch. Moving the electron beam can be achieved for example by an electric field that varies with time.

In another advantageous embodiment, the thickness measurement device can comprise a sample moving device for moving the sample during the measurement. The sample moving device can in particular move the sample in a continuous manner to achieve an easy design. In another embodiment, the sample moving device moves a sample non-continuously and for example in a controlled manner.

The thickness measurement device can comprise an electron beam deflection device that moves the electron beam over the patch and a sample moving device so that during the measurement the electron beam and the patch are moved at the same time. It can be necessary, for example, to move the patch for production reasons and also measure at the same time. It can thus be necessary to move the patch and the electron beam at the same time.

The detector can be an electron detector. Electrons can be detected easily so that the production and the operation of such a thickness measurement device are facilitated. The electron detector can be adapted for example to measure back scattered electrons, secondary electrons or Auger electrons. The detector can be adapted to filter certain energies or directions of electrons that are coming from the patch for a specific measurement.

The detector can be an x-ray detector. Such a detector can be used for example for elemental analysis. The x-ray detector can be adapted to filter certain directions or frequencies of x-rays coming from the patch.

A part of the substrate that is not covered by the patch can be used as a reference during the measurement. This can for example avoid complicated calculations and thus make the measurement easier and/or faster.

The inventive solution can also be used to improve a method of and a device for producing a patch of a layer structure on a substrate by applying a material onto the substrate and directing a high energetic electron beam onto the material, as for example described in EP 12 715 549.7. Such a device can already comprise an electron source and an electron acceleration device. To measure the electrical elements produced by such a device, in particular the thickness of the patch, the device can further comprise a detector for detecting a signal coming from the patch that is subjected to the electron beam. In particular, only one electron source can be used for the high energetic electron beam that is directed onto the material and for the electron beam that is used for measuring the thickness. The same applies for the electron acceleration device. The production and the measurement can be performed after each other. In an advantageous development, however, the thickness measurement can be made during the production. The electron beam that is used for heating can also be used for measuring the thickness and a signal coming from the patch.

In order to be able to have the above mentioned functions of producing/melting the patch and measuring its thickness in one device, the thickness measurement device can be adapted to melt the patch, in particular in a semi-finished state of the patch, with the electron beam. Again, the thickness measurement can be done after or during the melting.

The invention will now be described in an exemplary manner and with reference to the drawings. The exemplary embodiments and further developments are independent of each other and can be combined arbitrarily as desired.

In the Figures:
Fig. 1 shows a schematic side view of an inventive thickness measurement device and method for measuring the thickness of a patch;
Fig. 2 shows a schematic side view of an inventive method and a corresponding signal;
Fig. 3 shows a schematic perspective view of a further embodiment of a method;
Fig. 4 shows a schematic perspective view of a further embodiment of a method;
Figs. 5A, 5B, 5C, 5D show schematic top views of different scanning patterns for a method;
Fig. 6 shows an exemplary sample image taken by the inventive method.

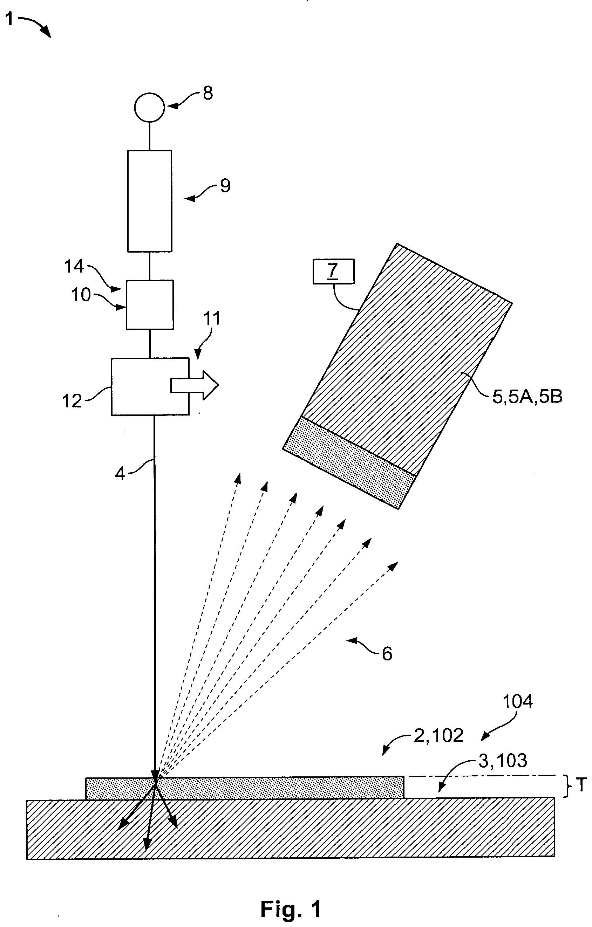

With reference to Figure 1, a thickness measurement device 1 for measuring a thickness T of a patch 2 of a layer structure on a substrate 3 is shown. The patch 2 can be a foil- or layer-like area that has been applied to the substrate 3. For example, a functional area 102 could have been printed on a base material 103 of an electrical element 104, for example a contact element. Such a functional area 102 can be for example a contact area where an electrical contact is made. Thus, the patch 2 and the substrate 3, that means the functional area 102 and the base material 103 can both be conductive. They can in particular be metals.

An electron beam 4 is directed onto the patch 2. This triggers several processes in the patch 2. Thus, a detector 5for detecting a signal 6 coming from the patch 2 that is subjected to the electron beam 4 can detect a signal. Subsequently, an analyzing device determines the thickness T of the patch 2 based on the signals 6 detected by the detector 5.

For generating the electron beam 4, the thickness measurement device 1 comprises an electron source 8. An electron acceleration device 9 accelerates the electrons to high speeds and high energies. An electron beam forming device 10 forms the electron beam 4. In this case, a thin electron beam is formed with which a high lateral resolution on the patch 2 can be achieved. The thickness measurement device 1 can comprise an electron beam focusing device 14 for focusing the electron beam 4.

The electron beam 4 is moved along a movement direction 11 so that the patch 2 and the electron beam 4 are moving relative to each other. To achieve the deflection, an electron beam deflection device 12 is adapted to move the electron beam 4 over the patch 2. Such an electron beam deflection device 12 can be for example a device that generates an electric or magnetic field, which in particular can vary over time so that the electron beam 4 moves.

The detector 5 can be adapted to measure electrons coming from the patch 2, for example backscattered electrons, secondary electrons or Auger electrons. The detector 5 is then an electron detector 5A. In another embodiment, the detector 5 can be an x-ray detector 5B that is adapted to detect x-rays coming from the patch 2 when it is subjected to the electron beam 4.

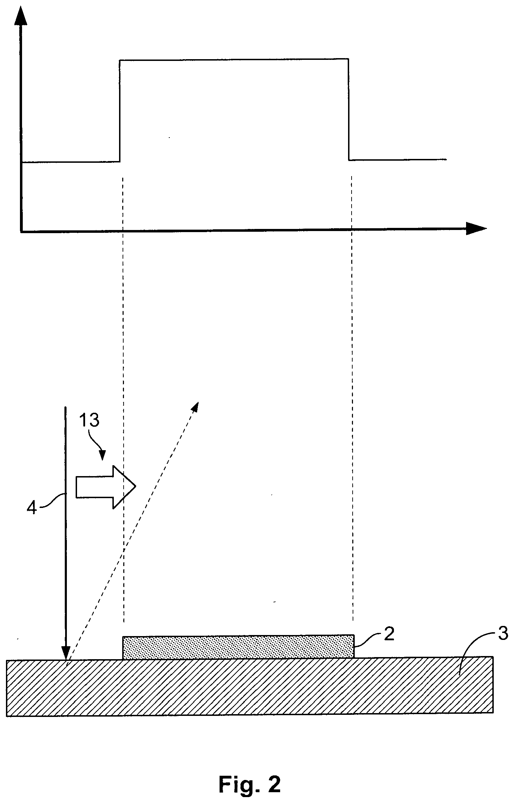

In Figure 2, the measurement is shown in a schematic way. The electron beam 4 and the patch 2 are moved relative to each other. The movement is indicated by the movement direction 13. In the upper part of the figure a signal that is detected is shown. It can be seen that it is a rectangular signal corresponding to the rectangular cross section of the patch shown in the lower part of Figure 2.

In order to allow the easiest analysis possible, a signal 6 coming from the substrate 3 can be detected and be taken as a reference signal for analyzing the thickness T of the patch 2. For example, the substrate 3 can be subjected to the electron beam 4 and only a signal 6 coming from the substrate 3 can be detected before or after a signal 6 coming from the patch 2 is detected. In an alternative embodiment, only signal 6 coming from the patch 2 can be detected. In this case, for example previous reference measurements can be taken for analyzing thickness T of the patch 2.

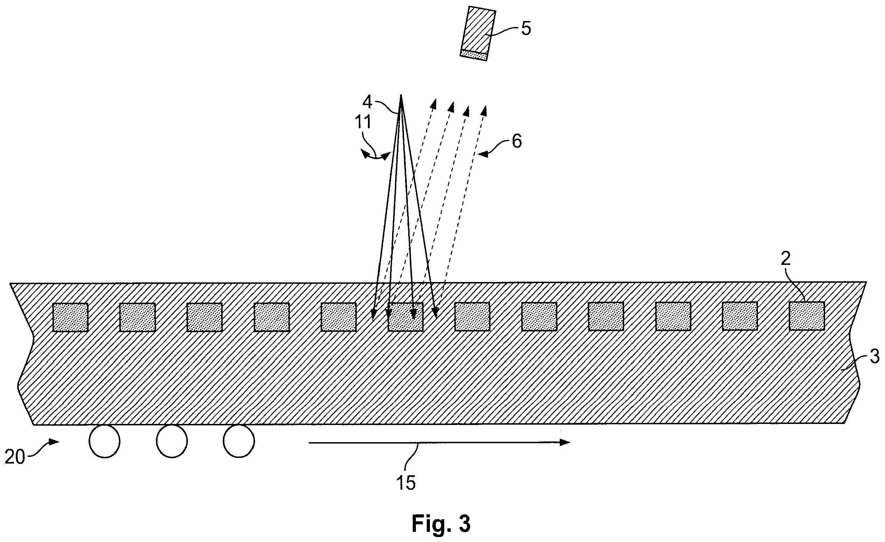

In Figure 3, a further embodiment of the method is depicted. Patches 2 on a strip-like substrate 3 are moved along a movement direction 15 by a sample moving device 20. The electron beam 4 is moved along a movement direction 11 over the patches 2. The electron beam 4 can also be directed to a patch free part measuring only the substrate 3 so that the signal from the substrate 3 can be taken as a reference signal for analyzing the thickness T of the patch 2. The electron beam 4 can be moved for example in the same direction as the strip-like base 3 with the patches 2. The electron beam 4 can also be moved counter to this direction. In the embodiment shown in Figure 3, the patches 2 have been produced on the substrate 3 before the thickness T is measured. In an advantageous development, the electron beam that is used for measuring the thickness T has been used for producing the patches 2, for example by melting a material that has been applied to the substrate.

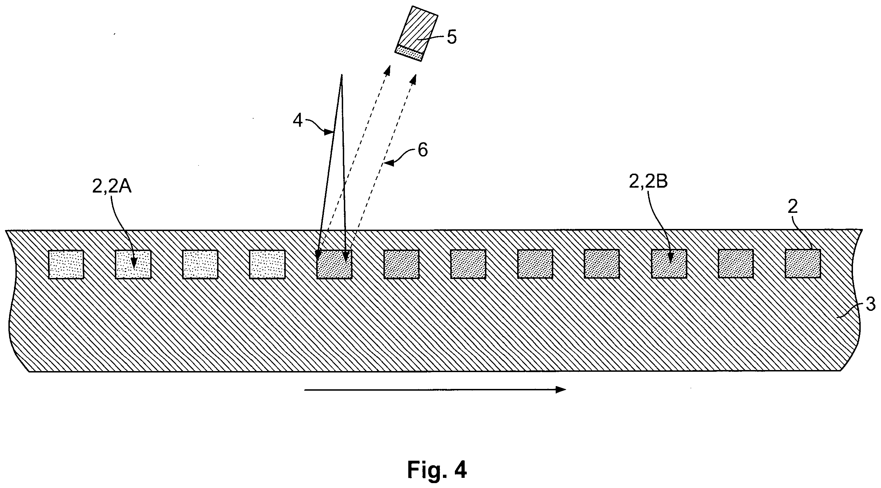

In another advantageous embodiment shown in Figure 4, the production of the patches 2 is united with the measurement of the thickness T. The left hand side of Figure 4 shows a state in which the patches 2 have been applied to the substrate 3, for example, by printing a material like a metal paste on the substrate 3. This material is then heated and melted by the electron beam 4 so that it forms a uniform layer and sticks to the substrate 3. At the same time, the thickness T is measured by detecting a signal 6 coming from the patches 2 that are being melted. A device that is adapted to produce the patches 2 on the substrate 3 by applying a material and heating or melting the material with an electron beam 4 can thus also be adapted to measure the thickness of the patches 2 by adding a detector 5 that measures the signals 6 coming from the patches 2. This can either be done by using the electron beam for measuring the thickness while the material is being melted as described.

In Figure 4, it is shown that the production of the finished patches 2, 2B is done at the same time as melting the material from the semi-finished patches 2, 2A.

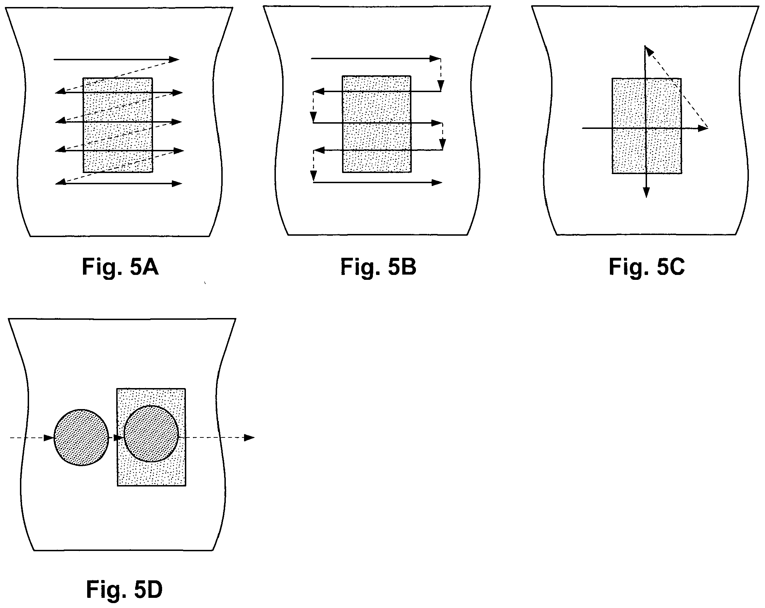

In Figures 5A, 5B, 5C and 5D, different scanning modes are shown. Figure 5A shows a scanning mode in which the scanning is performed in one direction only. The scanning takes place along several parallel lines that are spaced apart from each other in a direction perpendicular to the direction of the lines. After the scanning from left to the right in the first line is finished, the electron beam 4 is returned to the left side but moved further down. Subsequently, scanning along the second line from the left to the right is performed. Once this scanning is finished, the electron beam 4 is again returned to the left side and moved further downwards. This is repeated until the area around the patch 2 has been scanned.

In Figure 5B, the first line of scanning runs from the left to the right. Once the beam arrives at the right side, the beam is only shifted downwards. The subsequent measurement along the second line parallel to the first line is performed in a direction that is counter to the direction of the first scanning. Once the electron beam arrives at the left side, it is again shifted downwards and the third scanning takes place from left to right. Again, this is done until the area around the patch 2 is scanned.

In Figure 5C, the scanning is performed along two perpendicular lines. First a scanning from the left to the right through a centre of the patch 2 is performed. Afterwards, the electron beam 4 is moved to the top and the scanning is performed in an up and down direction and going through the centre of the patch 2.

In Figure 5D, a bigger spot of the electron beam 4 is used for scanning. The electron beam 4 is widened on the surface. With such a larger spot, it is easier to scan a bigger area in one go. However, the result will only give an average value of the thickness of the area subjected to the thick electron beam.

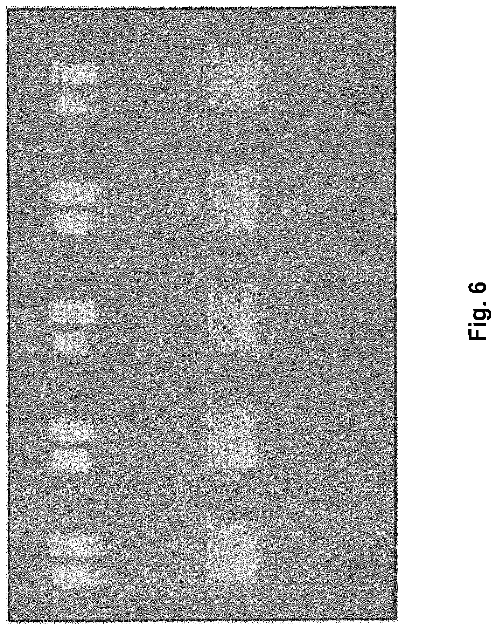

In Figure 6 an image created based on measurements taken with the inventive method is shown. As shown, the area is about 20mm in the vertical direction. In the upper area, pairs of silver patches are shown on the copper substrate. In the middle, a tin patch on the copper substrate is visible.

### Reference Signs

1. Thickness measurement device
2. Patch
2A. Semi-finished patch
2B. Finished patch
3. Substrate
4. Electron beam
5. Detector
5A. Electron detector
5B. X-ray detector
6. Signal
7. Analyzing device
8. Electron source
9. Electron acceleration device
10. Electron beam forming device
11. Movement direction
12. Electron beam deflection device
13. Movement direction
14. Electron beam focusing device
15. Movement direction
20. Sample moving device
102. Functional area
103. Base material
104. Electrical element

## Claims

1. Device for producing a patch (2) of a layer structure on a substrate (3) by applying a material onto the substrate (3) and melting the material by directing a high energetic electron beam (4) onto the material, and for measuring a thickness (T) of the patch (2), in particular a functional area (102) of an electrical element (104), comprising an electron source (8) for emitting an electron beam (4), an electron acceleration device (9) for accelerating the electrons in the electron beam (4), a detector (5) for detecting a signal (6) coming from the patch (2) that is subjected to the electron beam (4), the device being adapted to move the patch (2) and the electron beam (4) relative to each other, and wherein the device comprises an analyzing device (7) for determining the thickness (T) of the patch (2), wherein the device is adapted to melt the patch (2, 2A) with the electron beam (4).

2. Device according to claim 1, wherein the device is adapted to melt the patch (2) and measure the thickness (T) of the patch (2) at the same time.

3. Device according to one of claims 1 or 2, wherein the device is adapted to apply the material mechanically.

4. Device according to one of claims 1 to 3, where in the device is adapted to apply a metal paste.

5. Device according to one of claims 1 to 4, wherein the device is adapted to print the material onto the substrate.

6. Device according to one of claims 1 to 5, wherein the device comprises only one electron source (8) and/or only one electron acceleration device (9).

7. Method of measuring a thickness (T) of a patch (2) of a layer structure on a substrate (3), in particular a functional area (102) of an electric element (104), wherein the electron beam (4) is emitted, accelerated and directed to the patch (2), wherein the patch (2) is moved relative to the electron beam (4), and wherein a signal (6) coming from the patch (2) is detected and the thickness (T) of the patch (2) is determined, wherein the electron beam (4) is used for melting the patch (2, 2A).

8. Method according to claim 7, wherein a signal (6) coming from the substrate (3) is detected and taken as a reference signal for analyzing the thickness (T) of the patch (2).

9. Method of producing a patch (2) on a substrate (3) by applying a material onto the substrate (3) and directing a high energetic electron beam (4) onto the material, wherein the method comprises the method of measuring a thickness (T) of the patch (2) according to one of claims 7 or 8, wherein only one electron source (8) and/or only one electron acceleration device (9) are used.

## Patentansprüche

1. Vorrichtung zum Erzeugen eines Fleckens (2) einer Schichtstruktur auf einem Substrat (3) durch Aufbringen eines Materials auf das Substrat (3) und Aufschmelzen des Materials durch Richten eines hochenergetischen Elektronenstrahls (4) auf das Material und zum Messen einer Dicke (T) des Fleckens (2), insbesondere eines Funktionsbereichs (102) eines elektrischen Elements (104), umfassend eine Elektronenquelle (8) zum Emittieren eines Elektronenstrahls (4), eine Elektronenbeschleunigungsvorrichtung (9) zur Beschleunigung der Elektronen in dem Elektronenstrahl (4), einen Detektor (5) zum Erfassen eines Signals (6), das von dem dem Elektronenstrahl (4) ausgesetzten Flecken (2) stammt, wobei die Vorrichtung dazu eingerichtet ist, den Flecken (2) und den Elektronenstrahl (4) relativ zueinander zu bewegen, und die Vorrichtung eine Analysevorrichtung (7) zum Bestimmen der Dicke (T) des Fleckens (2) aufweist, wobei die Vorrichtung dazu eingerichtet ist, den Flecken (2, 2A) mit dem Elektronenstrahl (4) zu schmelzen.

2. Vorrichtung nach Anspruch 1, wobei die Vorrichtung dazu eingerichtet ist, den Flecken (2) zu schmelzen und gleichzeitig die Dicke (T) des Fleckens (2) zu messen.

3. Vorrichtung nach einem der Ansprüche 1 oder 2, wobei die Vorrichtung dazu eingerichtet ist, das Material mechanisch aufzubringen.

4. Vorrichtung nach einem der Ansprüche 1 bis 3, wobei die Vorrichtung dazu eingerichtet ist, eine Metallpaste aufzubringen.

5. Vorrichtung nach einem der Ansprüche 1 bis 4, wobei die Vorrichtung dazu eingerichtet ist, das Material auf das Substrat aufzudrucken.

6. Vorrichtung nach einem der Ansprüche 1 bis 5, wobei die Vorrichtung nur eine Elektronenquelle (8) und/oder nur eine Elektronenbeschleunigungsvorrichtung (9) aufweist.

7. Verfahren zum Messen einer Dicke (T) eines Fleckens (2) einer Schichtstruktur auf einem Substrat (3), insbesondere einem Funktionsbereich (102) eines elektrischen Elements (104), wobei der Elektronenstrahl (4) emittiert, beschleunigt und auf den Flecken (2) gerichtet wird, wobei der Fleck (2) relativ zu dem Elektronenstrahl (4) bewegt wird und ein von dem Flecken (2) kommendes Signal (6) erfasst und die Dicke (T) des Fleckens (2) bestimmt wird, wobei der Elektronenstrahl (4) zum Schmelzen des Fleckens (2, 2A) verwendet wird.

8. Verfahren nach Anspruch 7, bei dem ein von dem Substrat (3) kommendes Signal (6) erfasst und als Referenzsignal zur Analyse der Dicke (T) des Fleckens (2) herangezogen wird.

9. Verfahren zum Herstellen eines Fleckens (2) auf einem Substrat (3) durch Aufbringen eines Materials auf das Substrat (3) und Richten eines hochenergetischen Elektronenstrahls (4) auf das Material, wobei das Verfahren das Verfahren zum Messen einer Dicke (T) des Fleckens (2) nach einem der Ansprüche 7 oder 8 umfasst, wobei nur eine Elektronenquelle (8) und/oder nur eine Elektronenbeschleunigungsvorrichtung (9) verwendet werden.

## Revendications

1. Dispositif pour produire un patch (2) d'une structure en couches sur un substrat (3) en appliquant un matériau sur le substrat (3) et en faisant fondre le matériau en dirigeant un faisceau d'électrons à haute énergie (4) sur le matériau, et pour mesurer une épaisseur (T) du patch (2), en particulier une zone fonctionnelle (102) d'un élément électrique (104), comprenant une source d'électrons (8) pour émettre un faisceau d'électrons (4), un dispositif d'accélération d'électrons (9) pour accélérer les électrons dans le faisceau d'électrons (4), un détecteur (5) pour détecter un signal (6) provenant du patch (2) qui est soumis au faisceau d'électrons (4), le dispositif étant adapté pour déplacer le patch (2) et le faisceau d'électrons (4) l'un par rapport à l'autre, et dans lequel le dispositif comprend un dispositif d'analyse (7) pour déterminer l'épaisseur (T) du patch (2), dans lequel le dispositif est adapté pour faire fondre le patch (2, 2A) à l'aide du faisceau d'électrons (4).

2. Dispositif selon la revendication 1, dans lequel le dispositif est adapté pour faire fondre le patch (2) et mesurer l'épaisseur (T) du patch (2) en même temps.

3. Dispositif selon l'une des revendications 1 ou 2, dans lequel le dispositif est adapté pour appliquer le matériau mécaniquement.

4. Dispositif selon l'une des revendications 1 à 3, dans lequel le dispositif est adapté pour appliquer une pâte métallique.

5. Dispositif selon l'une des revendications 1 à 4, dans lequel le dispositif est adapté pour imprimer le matériau sur le substrat.

6. Dispositif selon l'une des revendications 1 à 5, dans lequel le dispositif comprend une seule source d'électrons (8) et/ou un seul dispositif d'accélération d'électrons (9).

7. Procédé de mesure d'une épaisseur (T) d'un patch (2) d'une structure en couches sur un substrat (3), en particulier une zone fonctionnelle (102) d'un élément électrique (104), dans lequel le faisceau d'électrons (4) est émis, accéléré et dirigé vers le patch (2), dans lequel le patch (2) est déplacé par rapport au faisceau d'électrons (4), et dans lequel un signal (6) provenant du patch (2) est détecté et l'épaisseur (T) du patch (2) est déterminée, dans lequel le faisceau d'électrons (4) est utilisé pour faire fondre le patch (2, 2A).

8. Procédé selon la revendication 7, dans lequel un signal (6) provenant du substrat (3) est détecté et pris comme signal de référence pour analyser l'épaisseur (T) du patch (2).

9. Procédé de production d'un patch (2) sur un substrat (3) en appliquant un matériau sur le substrat (3) et en dirigeant un faisceau d'électrons à haute énergie (4) sur le matériau, dans lequel le procédé comprend le procédé de mesure d'une épaisseur (T) du patch (2) selon l'une des revendications 7 ou 8, dans lequel une seule source d'électrons (8) et/ou un seul dispositif d'accélération d'électrons (9) sont utilisés.
